# EUROPEAN PATENT APPLICATION

(11) **EP 4 847 175 A1**
(43) Date of publication of application: **02.12.2026**
(21) Application number: 24959293.2
(22) Date of filing: 31.10.2024
(51) Int. Cl.: B23B 27/14

(54) **CUTTING TOOL**

(71) Applicant: SUMITOMO ELECTRIC INDUSTRIES, LTD., Osaka-shi, Osaka 541-0041 (JP)
(72) Inventor: TSUKIHARA, Nozomi, Osaka-shi, Osaka 541-0041 (JP); FUKUI, Haruyo, Osaka-shi, Osaka 541-0041 (JP); YAMASAKI, Takahiro, Osaka-shi, Osaka 541-0041 (JP); MOMIDA, Hiroyoshi, Osaka-shi, Osaka 541-0041 (JP)
(74) Representative: Boult Wade Tennant LLP
(86) International application number: PCT/JP2024/038911
(87) International publication number: WO 2026/094212

(57) **Abstract**

A cutting tool includes: a substrate; and a coating film disposed on the substrate, wherein the coating film includes a first layer consisting of Ti_{1-a-b}AlₐSc_{b}N, and the a is 0.35 or more and 0.65 or less, and the b is 0.01 or more and 0.10 or less.

## Description

### TECHNICAL FIELD

The present disclosure relates to a cutting tool.

### BACKGROUND ART

Conventionally, a cutting tool including a substrate and a coating film disposed on the substrate has been used for cutting (PTL 1).

### CITATION LIST

### PATENT LITERATURE

PTL 1: Japanese Patent Laying-Open No. 2015-54995

### SUMMARY OF INVENTION

A cutting tool according to the present disclosure is a cutting tool comprising: a substrate; and a coating film disposed on the substrate, wherein the coating film includes a first layer consisting of Ti_{1-a-b}AlₐSc_{b}N, the a is 0.35 or more and 0.65 or less, and the b is 0.01 or more and 0.10 or less.

### BRIEF DESCRIPTION OF DRAWINGS

[Fig. 1] Fig. 1 is a schematic view of an exemplary cutting tool.
[Fig. 2] Fig. 2 is a schematic enlarged cross sectional view of an exemplary cutting tool according to a first embodiment.
[Fig. 3] Fig. 3 is a schematic enlarged cross sectional view of another exemplary cutting tool according to the first embodiment.
[Fig. 4] Fig. 4 is a schematic enlarged cross sectional view of another exemplary cutting tool according to the first embodiment.
[Fig. 5] Fig. 5 is a schematic enlarged cross sectional view of an exemplary cutting tool according to a second embodiment.

### DETAILED DESCRIPTION

### [Problem to be Solved by the Present Disclosure]

From the viewpoint of cost reduction, there has been required a cutting tool having a long tool life even in processing a difficult-to-cut material such as a nickel-based alloy.

Thus, it is an object of the present disclosure to provide a cutting tool having a long tool life even in processing a difficult-to-cut material such as a nickel-based alloy.

### [Advantageous Effect of the Present Disclosure]

According to the present disclosure, it is possible to provide a cutting tool having a long tool life even in processing a difficult-to-cut material such as a nickel-based alloy.

### [Description of Embodiments]

First, embodiments of the present disclosure will be listed and described.
(1) A cutting tool according to the present disclosure is a cutting tool comprising: a substrate; and a coating film disposed on the substrate, wherein the coating film includes a first layer consisting of Ti_{1-a-b}AlₐSc_{b}N, the a is 0.35 or more and 0.65 or less, and the b is 0.01 or more and 0.10 or less.
   According to the present disclosure, it is possible to provide a cutting tool having a long tool life even in processing a difficult-to-cut material such as a nickel-based alloy.
(2) In (1), a thickness of the first layer may be 0.3 µm or more and 15.0 µm or less. Thus, the tool life is further improved.
(3) In (1) or (2), the coating film may further include a second layer disposed between the substrate and the first layer, the second layer may consist of a compound consisting of titanium and at least one element selected from a group consisting of carbon, nitrogen, and oxygen, and a thickness of the second layer may be 10 nm or more and 100 nm or less.
   According to this, adhesion between the substrate and the first layer is improved to suppress detachment of the first layer during use of the cutting tool, thereby further improving the tool life.
(4) In any one of (1) to (3), the coating film may further include a third layer provided on a side of the first layer opposite to the substrate, the third layer may consist of TiCN or TiAlScCN, and a thickness of the third layer may be 0.1 µm or more and 1.0 µm or less.
   Since the carbonitride has an excellent slidability, the slidability of the coating film is improved in processing a difficult-to-cut material such as a nickel-based alloy when the third layer is present on the surface side of the coating film. Thus, a cutting point is less likely to have a high temperature and a load on the tool is reduced, thereby further improving the tool life.
(5) A cutting tool according to the present disclosure is a cutting tool comprising: a substrate; and a coating film disposed on the substrate, wherein the coating film includes an A layer consisting of Ti_{1-c-d-e}Al_{c}Sc_{d}MₑN, the M is one or both of boron and silicon, the c is 0.35 or more and 0.65 or less, the d is 0.01 or more and 0.10 or less, and the e is 0.01 or more and 0.05 or less.
   According to the present disclosure, it is possible to provide a cutting tool having a long tool life even in processing a difficult-to-cut material such as a nickel-based alloy.
(6) In (5), a thickness of the A layer may be 0.3 µm or more and 15.0 µm or less. Thus, the tool life is further improved.
(7) In (5) or (6), the coating film may further include a B layer disposed between the substrate and the A layer, the B layer may consist of a compound consisting of titanium and at least one element selected from a group consisting of carbon, nitrogen, and oxygen, and a thickness of the B layer may be 10 nm or more and 100 nm or less.
   According to this, the adhesion between the substrate and the A layer is improved, detachment of the A layer during the use of the cutting tool is suppressed, thereby further improving the tool life.
(8) In any one of (5) to (7), the coating film may further include a C layer provided on a side of the A layer opposite to the substrate, the C layer may consist of TiCN or TiAlScMCN, the M may be one or both of boron and silicon, and a thickness of the C layer may be 0.1 µm or more and 1.0 µm or less.

Since the carbonitride has an excellent slidability, the slidability of the coating film is improved in processing a difficult-to-cut material such as a nickel-based alloy when the C layer is present on the surface side of the coating film. Thus, a cutting point is less likely to have a high temperature and a load on the tool is reduced, thereby further improving the tool life.

### [Details of Embodiments of the Present Disclosure]

A specific example of the cutting tool of the present disclosure will be described below with reference to figures. In the figures of the present disclosure, the same reference characters represent the same or corresponding portions. Further, a dimensional relation such as a length, a width, a thickness, or a depth is appropriately changed for clarity and simplification of the figures, and therefore do not necessarily represent an actual dimensional relation.

In the present disclosure, the expression "A to B" means A or more and B or less, and when no unit is indicated for A and a unit is indicated only for B, the unit of A is the same as the unit of B.

When a compound or the like is expressed by a chemical formula in the present disclosure and an atomic ratio is not particularly limited, it is assumed that all the conventionally known atomic ratios are included, and the atomic ratio should not be necessarily limited only to one in the stoichiometric range.

In the present disclosure, when one or more numerical values are described as each of lower and upper limits of a numerical range, it is assumed that a combination of any one numerical value described as the lower limit and any one numerical value described as the upper limit is also disclosed.

In the present disclosure, the terms "comprise", "include", "have", and variations thereof are open-ended terms. Each of the open-ended terms may or may not further include an additional element in addition to an essential element. The description "consist of" is a closed term. It should be noted that even a configuration expressed by such a closed term can include an impurity introduced in an ordinary case or an additional element irrelevant to the target technology.

### [First Embodiment: Cutting Tool (1)]

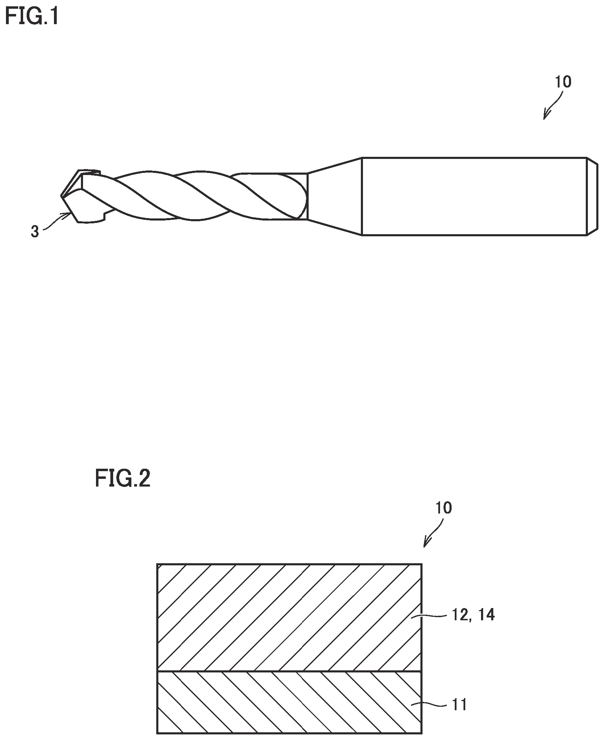

A cutting tool according to an embodiment of the present disclosure will be described with reference to Figs. 1 to 4. A cutting tool 10 according to one embodiment (hereinafter, also referred to as "first embodiment") of the present disclosure includes: a substrate 11; and a coating film 14 disposed on substrate 11. Coating film 14 includes a first layer 12 consisting of Ti_{1-a-b}AlₐSc_{b}N. The a is 0.35 or more and 0.65 or less. The b is 0.01 or more and 0.10 or less.

According to the present disclosure, it is possible to provide a cutting tool having a long tool life even in processing a difficult-to-cut material such as a nickel-based alloy. This is presumably due to the following reason.

Since the nickel-based alloy has a high specific strength among difficult-to-cut materials, a cutting edge temperature of the cutting tool is likely to be increased when processing is performed using the cutting tool. Therefore, from the viewpoint of improving the tool life of the cutting tool, it is important that the strength and heat resistance of the coating film are excellent.

Since the first layer includes the Al and the a is 0.35 or more, the hardness and heat resistance of the first layer are improved. Since the a is 0.65 or less, the hardness can be suppressed from being decreased due to generation of hexagonal crystal in the first layer.

Since the first layer includes the Sc, the Sc is oxidized during the cutting to generate a passive state consisting of Sc₂O₃. Since the Sc₂O₃ has a very high melting point of 2485°C, the passive state consisting of the Sc₂O₃ can be stably present even in processing a difficult-to-cut material such as a nickel-based alloy. Therefore, stability of tool performance of the cutting tool is improved.

The Sc₂O₃ causes a so-called "keying on effect" in which the Sc₂O₃ is precipitated at a crystal grain boundary of TiAlScN, thereby preventing oxygen from being diffused from a surface of the coating film to inside of the coating film through the crystal grain boundary. With the keying on effect, oxidation resistance of the coating film is significantly improved. Further, due to the keying on effect, reactivity between the workpiece and the coating film can be suppressed, thereby reducing a friction coefficient between the workpiece and the coating film.

Since the lattice constant of the ScN is 4.51 Å and is larger than each of the lattice constant of TiN of 4.23 Å and the lattice constant of AlN of 4.12 Å, strain is introduced into the first layer, with the result that the structure of the first layer becomes fine. Thus, the hardness of the first layer becomes high, thereby improving the wear resistance of the first layer.

Since the b is 0.01 or more in the first layer, the Sc₂O₃ is sufficiently formed, thereby improving the stability of the tool performance of the cutting tool, the oxidation resistance and reaction resistance of the coating film, and the wear resistance of the first layer. Since the b is 0.10 or less, toughness is suppressed from being decreased, thereby improving chipping resistance.

Since the first layer includes Ti and an amount of Ti is 1-a-b (0.35≤a≤0.65, 0.01≤b≤0.10), the high-temperature strength of the first layer is improved.

The nickel-based alloy, which serves as a workpiece, includes Ni, Co, and Fe as main components, and further has another alloy element added therein such as Cr. When the Cr is contained in the coating film, the components in the coating film and the workpiece are diffused therebetween at the time of the cutting to promote wear, so that no Cr is preferably included in the coating film. Since the first layer does not include Cr in the cutting tool of the first embodiment, the wear due to the diffusion of the components in the coating film and the workpiece therebetween is suppressed.

### <Cutting Tool>

Examples of the cutting tool according to the first embodiment include a drill, an end mill, an indexable cutting insert for drill, an indexable cutting insert for end mill, an indexable cutting insert for milling, an indexable cutting insert for turning, a metal saw, a gear cutting tool, a reamer, a tap, and the like.

Fig. 1 is a schematic view of an exemplary cutting tool. Cutting tool 10 is an end mill and has a cutting edge ridgeline 3.

### <Substrate>

As the composition of substrate 2, any conventionally known composition can be used. For example, any one of a cemented carbide (such as a WC-based cemented carbide, a cemented carbide including WC and Co, or a cemented carbide to which a carbonitride of Ti, Ta, Nb or the like is further added), a cermet (having TiC, TiN, TiCN, or the like as a main component), a high-speed steel, a ceramic (such as titanium carbide, silicon carbide, silicon nitride, aluminum nitride, or aluminum oxide), a cubic boron nitride sintered material, or a diamond sintered material can be used.

The composition of the substrate may be the WC-based cemented carbide or the cermet (particularly, the TiCN-based cermet) from the viewpoint of excellent balance between hardness and strength at a high temperature. The substrate consisting of such a WC-based cemented carbide or cermet can contribute to a long life of the cutting tool.

### <Coating Film>

In the cutting tool according to the first embodiment, the coating film can coat at least a portion of the substrate involved in cutting. The portion of the substrate involved in cutting means, for example, a region at a distance of 50 µm or less from a cutting edge ridgeline in a surface of the substrate. The coating film may coat the entire surface of the substrate, or may coat the entire surface of the portion of the substrate involved in cutting. As long as the effects of the cutting tool of the present disclosure are not impaired, a configuration in which the coating film is not formed on a part of the portion of the substrate involved in the cutting is not deviated from the scope of the first embodiment. As long as the effects of the cutting tool of the present disclosure are not impaired, a partially different configuration of the coating film is not deviated from the scope of the first embodiment.

The coating film includes the first layer consisting of Ti_{1-a-b}AlₐSc_{b}N. As shown in Fig. 2, first layer 12 may be provided directly on substrate 11.

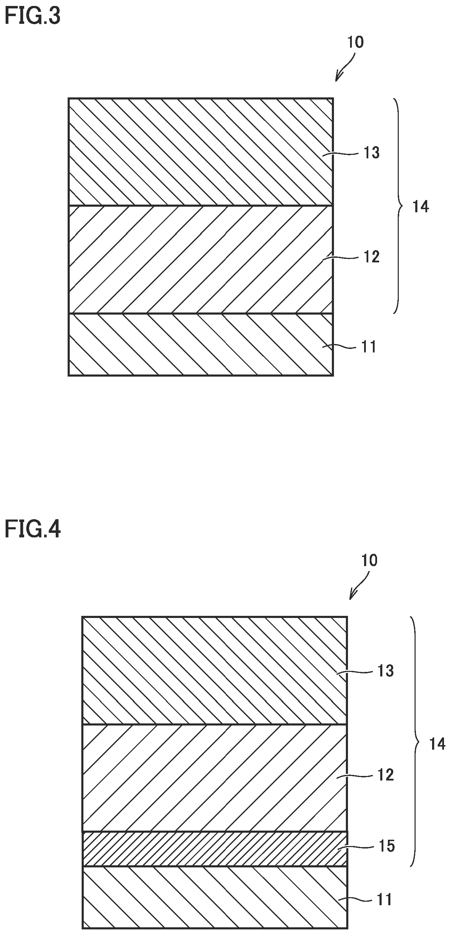

Coating film 14 can include another layer in addition to first layer 12. As shown in Figs. 3 and 4, coating film 14 may include a third layer 13 provided on a side of first layer 12 opposite to substrate 11. As shown in Fig. 4, coating film 14 may include a second layer 15 disposed between substrate 11 and first layer 12.

The thickness of the coating film may be 0.3 µm or more and 15 µm or less, 0.5 µm or more and 12 µm or less, 1.0 µm or more and 10 µm or less, or 2.0 µm or more and 9.0 µm or less. When the thickness of the coating film is less than 0.3 µm, the wear resistance tends to be decreased. When the thickness of the coating film is more than 15 µm, chipping of the coating film is likely to occur at the initial stage of the cutting, with the result that the life of the cutting tool tends to be short.

The thickness of the coating film is measured by observing a cross section of the coating film using a SEM (scanning electron microscope). Specifically, a cross sectional sample is observed for an observation area of 100 to 500 µm² at an observation magnification of 5000 to 10000 times so as to measure thickness ranges at three locations in one visual field, and the average value thereof is defined as "thickness". The thickness of each of below-described layers is also measured in the same manner unless otherwise stated particularly.

### <Composition of First Layer>

In the cutting tool of the first embodiment, the first layer consists of Ti_{1-a-b}AlₐSc_{b}N, the a is 0.35 or more and 0.65 or less, and the b is 0.01 or more and 0.10 or less.

The a is 0.35 or more and 0.65 or less, may be 0.45 or more and 0.62 or less, or may be 0.50 or more and 0.60 or less.

The b is 0.01 or more and 0.10 or less, may be 0.02 or more and 0.09 or less, may be 0.03 or more and 0.07 or less, or may be 0.03 or more and 0.05 or less.

The 1-a-b may be 0.25 or more and 0.64 or less, may be 0.31 or more and 0.52 or less, or may be 0.35 or more and 0.47 or less.

Each of the a and the b is measured by performing an elemental analysis onto the cross section of the coating film using an energy dispersive X-ray spectrometer (EDX) accompanied with a transmission electron microscope (TEM). Specifically, the a and the b are found in the following manner: energy of characteristic X-rays generated when an electron beam is applied to a sliced sample using the TEM-EDX and the number of times of generation of the characteristic X-rays are measured to perform the elemental analysis. In the Ti_{1-c-d-e}Al_{c}Sc_{d}MₑN described in the second embodiment, the c, the d, and the e are also measured in the same manner. As long as the measurement is performed using the same cutting tool, it has been confirmed that there are no variations in measurement results even when the measurement positions are freely selected.

The first layer may include an inevitable impurity in addition to the Ti_{1-a-b}AlₐSc_{b}N as long as the effects of the cutting tool of the first embodiment are not impaired. Examples of the inevitable impurity include oxygen, carbon, and the like. The total content ratio of the inevitable impurity in the first layer may be 0 atomic% or more and 1 atomic% or less. The content ratio of the inevitable impurity is measured in the same manner as in the method of measuring the a and the b as described above. Similarly, each of the second layer, the third layer, an A layer, a B layer, and a C layer described below may include an inevitable impurity as long as the effects of the cutting tool of the present disclosure are not impaired.

In the present disclosure, in the composition Ti_{1-a-b}AlₐSc_{b}N of the first layer, a ratio A_{N1}/A_{M1} of the number of atoms A_{N1} of N to the total number of atoms A_{M1} of Ti, Al, and Sc is 0.8 or more and 1.2 or less. The ratio A_{N1}/A_{M1} can be measured by the Rutherford backscattering (RBS) method. It has been confirmed that the effects of the present disclosure are not impaired when the ratio A_{N1}/A_{M1} falls within the above range.

### <Thickness of First Layer>

The thickness of the first layer may be 0.3 µm or more and 15.0 µm or less. When the thickness of the first layer is 0.3 µm or more, the stability of the tool performance of the cutting tool, the oxidation resistance and reaction resistance of the coating film, and the wear resistance of the first layer are improved. When the thickness of the first layer is 15.0 µm or less, occurrence of chipping of the coating film at the initial stage of the cutting is suppressed. The thickness of the first layer may be 0.5 µm or more and 12.0 µm or less, may be 1.0 µm or more and 10.0 µm or less, may be 1.0 µm or more and 6.0 µm or less, or may be 2.0 µm or more and 4.0 µm or less.

### <Second Layer>

In the cutting tool according to the first embodiment, the coating film may further include the second layer disposed between the substrate and the first layer. The second layer may be disposed directly on the substrate.

The second layer may consist of a compound consisting of titanium and at least one element selected from a group consisting of carbon, nitrogen, and oxygen. The second layer may consist of TiC, TiCN, TiCNO or TiN.

The thickness of the second layer may be 10 nm or more and 100 nm or less. When the thickness of the second layer is 10 nm or more and 100 nm or less, the effect of improving the adhesion between the substrate and the first layer is excellent. The thickness of the second layer may be 15 nm or more and 80 nm or less, or 20 nm or more and 70 nm or less.

### <Third Layer>

In the cutting tool according to the first embodiment, the coating film may further include the third layer provided on a side of the first layer opposite to the substrate. The third layer may be disposed on the outermost surface of the coating film. The third layer may consist of TiCN or TiAlScCN.

When the third layer consists of TiCN, a predetermined color can be given by adjusting the composition ratio of N and C. Thus, the external appearance of the cutting tool can be provided with a design property and distinguishability, which is commercially advantageous.

When the third layer consists of TiAlScCN, the atomic ratio of Ti, Al, and Sc in the third layer may be the same as the atomic ratio of Ti, Al, and Sc in the first layer. Specifically, when the atomic ratio of Ti, Al and Sc in the first layer is Ti:Al:Sc=1-a-b:a:b, the atomic ratio of Ti, Al and Sc in the third layer may also be Ti:Al:Sc=1-a-b:a:b. Thus, when the coating film is produced by a PVD method, the first layer and the third layer can be produced using the same target, which is advantageous in terms of cost.

The thickness of the third layer may be 0.1 µm or more and 1.0 µm or less. When the thickness of the third layer is 0.1 µm or more, the effect of improving the slidability of the coating film is excellent. When the thickness of the third layer is more than 1.0 µm, the effect of improving the slidability of the coating film tends to be unable to be further obtained. Therefore, in consideration of cost, the thickness of the third layer may be 1.0 µm or less. The thickness of the third layer may be 0.2 µm or more and 0.8 µm or less, or may be 0.3 µm or more and 0.7 µm or less.

### [Second Embodiment: Cutting Tool (2)]

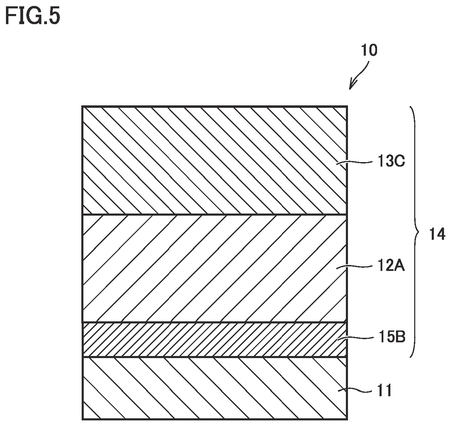

A cutting tool according to another embodiment of the present disclosure will be described with reference to Fig. 5. A cutting tool 10 according to the other embodiment (hereinafter, also referred to as "second embodiment") of the present disclosure includes a substrate 11 and a coating film 14 disposed on substrate 11. Coating film 14 includes an A layer 12A consisting of Ti_{1-c-d-e}Al_{c}Sc_{d}MₑN. The M is one or both of boron and silicon. The c is 0.35 or more and 0.65 or less. The d is 0.01 or more and 0.10 or less. The e is 0.01 or more and 0.05 or less.

According to the present disclosure, it is possible to provide a cutting tool having a long tool life even in processing a difficult-to-cut material such as a nickel-based alloy. This is presumably due to the following reason.

Since the nickel-based alloy has a high specific strength among difficult-to-cut materials, a cutting edge temperature of the cutting tool is likely to be increased when processing is performed using the cutting tool. Therefore, from the viewpoint of improving the tool life of the cutting tool, it is important that the strength and heat resistance of the coating film are excellent.

When the A layer includes the Al and the c is 0.35 or more, the hardness and heat resistance of the A layer are improved. When the c is 0.65 or less, the hardness can be suppressed from being decreased due to generation of hexagonal crystal in the A layer.

Since the A layer includes the Sc, the following effects can be obtained as described in the first embodiment. The Sc is oxidized during cutting to generate a passive state consisting of Sc₂O₃. The generation of the Sc₂O₃ leads to improved stability of the tool performance of the cutting tool. With the keying on effect by the Sc₂O₃, the oxidation resistance of the coating film is significantly improved. With the keying on effect by the Sc₂O₃, reactivity between the workpiece and the coating film can be suppressed, thereby reducing a coefficient of friction with the workpiece. Since the A layer includes the Sc, strain is introduced into the A layer, with the result that the structure of the A layer becomes fine. Thus, the hardness of the A layer becomes high, thereby improving the wear resistance of the A layer.

Since the d is 0.01 or more in the A layer, the Sc₂O₃ is sufficiently formed, thereby improving the stability of the tool performance of the cutting tool, the oxidation resistance and reaction resistance of the coating film, and the wear resistance of the A layer. Since the d is 0.10 or less, toughness is suppressed from being decreased, thereby improving the chipping resistance.

The A layer includes one or both of boron (B) and silicon (Si). According to this, the structure of the A layer is likely to be densified, thereby facilitating improvement of the film strength of the A layer.

Since the e is 0.01 or more in the A layer, an excellent effect of improving the film strength can be obtained. When the e is more than 0.05, excessive lattice strain is introduced into the A layer to increase film stress, with the result that film breakage is likely to occur. When the e is 0.05 or less, the occurrence of the film breakage is suppressed.

Since the A layer includes the Ti and the amount of the Ti is 1-c-d-e (0.35≤c≤0.65, 0.01≤d≤0.10, 0.01≤e≤0.05), the high-temperature strength of the A layer is improved.

Since the A layer does not include Cr in the cutting tool of the second embodiment, the wear due to the diffusion of the components in the coating film and the workpiece consisting of the nickel-based alloy therebetween is suppressed.

Coating film 14 may further include a B layer 15B disposed between substrate 11 and A layer 12A. Coating film 14 may further include a C layer 13C provided on a side of A layer 12A opposite to substrate 11. The coating film may include an intermediate layer disposed between the A layer and the B layer or between the A layer and the C layer.

The cutting tool of the second embodiment has the same configuration as that of the first embodiment except that the coating film includes the A layer instead of the first layer, includes the B layer instead of the second layer, and includes the C layer instead of the third layer. It should be noted that the B layer has the same configuration as that of the second layer of the first embodiment. Hereinafter, the A layer and the C layer will be described.

### <Composition of A Layer>

In the cutting tool of the second embodiment, the A layer consists of Ti_{1-c-d-e}Al_{c}Sc_{d}MₑN, the M is one or both of boron and silicon, the c is 0.35 or more and 0.65 or less, the d is 0.01 or more and 0.10 or less, and the e is 0.01 or more and 0.05 or less.

The M may be boron or silicon.

The c is 0.35 or more and 0.65 or less, may be 0.45 or more and 0.62 or less, or may be 0.50 or more and 0.60 or less.

The d is 0.01 or more and 0.10 or less, may be 0.02 or more and 0.09 or less, may be 0.03 or more and 0.07 or less, or may be 0.03 or more and 0.05 or less.

The e is 0.01 or more and 0.05 or less, or may be 0.02 or more and 0.04 or less.

The 1-c-d-e may be 0.20 or more and 0.63 or less, 0.25 or more and 0.51 or less, or 0.28 or more and 0.46 or less.

In the present disclosure, in the composition Ti_{1-c-d-e}Al_{c}Sc_{d}MₑN of the A layer, the ratio A_{N2}/A_{M2} of the number of atoms A_{N2} of N to the total number of atoms A_{M2} of Ti, Al, Sc, and M is 0.8 or more and 1.2 or less. The ratio A_{N2}/A_{M2} can be measured by the Rutherford backscattering (RBS) method. It has been confirmed that the effects of the present disclosure are not impaired when the ratio A_{N2}/A_{M2} is in the above range.

### <Thickness of A Layer>

The thickness of the A layer may be 0.3 µm or more and 15.0 µm or less. When the thickness of the A layer is 0.3 µm or more, the stability of the tool performance of the cutting tool, the oxidation resistance and reaction resistance of the coating film, and the wear resistance of the A layer are improved. When the thickness of the A layer is 15.0 µm or less, the occurrence of the chipping of the coating film at the initial stage of the cutting is suppressed. The thickness of the A layer may be 0.5 µm or more and 12.0 µm or less, may be 1.0 µm or more and 10.0 µm or less, may be 1.0 µm or more and 6.0 µm or less, or may be 2.0 µm or more and 4.0 µm or less.

### <C Layer>

In the cutting tool of the second embodiment, the coating film may further include the C layer provided on the side of the A layer opposite to the substrate. The C layer may be disposed on the outermost surface of the coating film. The C layer may consist of TiCN or TiAlScMCN.

When the C layer consists of TiCN, a predetermined color can be given by adjusting the composition ratio of N and C. Thus, the external appearance of the cutting tool can be provided with a design property and distinguishability, which is commercially advantageous.

When the C layer consists of TiAlScMCN, the atomic ratio of Ti, Al, Sc, and M in the C layer may be the same as the atomic ratio of Ti, Al, Sc, and M in the A layer. Specifically, when the atomic ratio of Ti, Al, Sc, and M in the A layer is Ti:Al:Sc:M=1-c-d-e:c:d:e, the atomic ratio of Ti, Al, Sc, and M in the C layer may also be Ti:Al:Sc:M=1-c-d-e:c:d:e. According to this, when the coating film is formed by a PVD method, the A layer and the C layer can be formed using the same target, which is advantageous in terms of cost.

The thickness of the C layer may be 0.1 µm or more and 1.0 µm or less. When the thickness of the C layer is 0.1 µm or more, the effect of improving the slidability of the coating film is excellent. When the thickness of the C layer is more than 1.0 µm, the effect of improving the slidability of the coating film tends to be unable to be further obtained. Therefore, in consideration of cost, the thickness of the C layer may be 1.0 µm or less. The thickness of the C layer may be 0.2 µm or more and 0.8 µm or less, or may be 0.3 µm or more and 0.7 µm or less.

### [Third Embodiment: Method of Manufacturing Cutting Tool]

In a third embodiment, a method of manufacturing the cutting tool according to the first embodiment or the second embodiment will be described. The method of manufacturing the cutting tool according to the third embodiment includes: a first step of preparing the substrate; and a second step of forming the coating film on the substrate. The second step includes a step of forming the first layer or the A layer. Details of each step will be described below.

### <First Step>

In the first step, the substrate is prepared. As the substrate, the substrate described in the first embodiment can be used. Any conventionally known substrate can be prepared.

### <Second Step>

In the second step, the coating film is formed on the substrate. The second step includes the step of forming the first layer or the A layer.

In the step of forming the first layer or the A layer, the first layer or the A layer is formed using the physical vapor deposition (PVD) method. In order to improve the wear resistance of the coating film including the first layer or the A layer, it is preferable to form a layer consisting of a compound having high crystallinity. As a result of reviewing various methods as a method of forming the first layer or the A layer, the present inventors have found that it is preferable to use the physical vapor deposition method.

As the PVD method, at least one selected from a group consisting of a cathode arc ion plating method, a balanced magnetron sputtering method, an unbalanced magnetron sputtering method, and a HiPIMS method can be used. Particularly, the cathode arc ion plating method, which allows for a high ionization ratio of a source material element, is preferably used. In the case of using the cathode arc ion plating method, since ion bombardment treatment for metal can be performed onto the surface of the substrate before the first layer or the A layer is formed, adhesion between the substrate and the coating film is significantly improved.

The cathode arc ion plating method can be performed by: placing the substrate in an apparatus and placing a target as a cathode; and then applying high voltage to the target to generate arc discharge so as to ionize and evaporate atoms that constitute the target; and depositing a substance on the substrate, for example.

The balanced magnetron sputtering method can be performed by: placing the substrate in an apparatus and placing a target on a magnetron electrode that has a magnet to form a balanced magnetic field; applying high-frequency electric power between the magnetron electrode and the substrate to generate gas plasma; and allowing gas ions generated by the generation of this gas plasma to collide with the target; and depositing atoms released from the target on the substrate, for example.

The unbalanced magnetron sputtering method can be performed by setting the magnetic field, which is to be generated by the magnetron electrode, to be unbalanced in the above-described balanced magnetron spattering method, for example. The HiPIMS method, by which higher voltage can be applied to obtain a dense film, can also be used.

### <Other Steps>

The second step can include a surface treatment step such as surface grinding or shot blasting in addition to the step of forming the first layer or the A layer. Moreover, the second step can include a step of forming other layer(s) (at least one of the second layer, the third layer, the B layer, the C layer, and the intermediate layer). Each of these other layers can be formed by a conventionally known chemical vapor deposition method or physical vapor deposition method. From the viewpoint that the first layer or the A layer and the other layer(s) can be continuously formed in one physical vapor deposition apparatus, the other layer(s) can be formed by the physical vapor deposition method.

### Examples

The present embodiment will be described more specifically with reference to examples. However, the present embodiment is not limited by these examples.

### <Production of Cutting Tool>

### <<First Step>>

As each of substrates of samples 1 to 17 and samples 101 to 105, a ball end mill (two cutting edges; ball radius of 5 mm) composed of cemented carbide was prepared. As each of substrates of samples 21 to 39 and samples 121 to 133, a ball end mill (two cutting edges; ball radius of 3 mm) composed of cemented carbide was prepared.

### <<Second Step>>

The substrate was set at a predetermined position of an arc ion plating apparatus (manufactured by Kobe Steel; product name: AIP). A target was set at an arc evaporation source in the apparatus.

When the second layer or the B layer was formed on the substrate, the second layer or the B layer was formed by the following method. In a state of rotating the substrate, while introducing at least one of nitrogen, methane, and oxygen into the apparatus as reaction gas, an arc current of 150 A was supplied to the target with the temperature of the substrate being maintained at 500°C, the reaction gas pressure being maintained at 1 Pa, and the voltage of the bias power supply being maintained at a certain constant value in a range of 50 V to 800 V, thereby generating metal ions from the target to form, on the substrate, a second layer having a composition shown in Table 1 or a B layer having a composition shown in Tables 2 and 3. The composition of the target is Ti. When the first layer or the A layer is formed directly on the substrate, the second layer or the B layer is not formed.

The first layer was formed directly on the substrate or on the second layer. Alternatively, the A layer was formed directly on the substrate or on the B layer. **In a** state of rotating the substrate, while introducing nitrogen into the apparatus as reaction gas, an arc current of 150 A was supplied to the target with the temperature of the substrate being maintained at 500°C, the reaction gas pressure being maintained at 4 Pa, and the voltage of the bias power supply being maintained at a certain constant value in a range of 50 V to 300 V, thereby generating metal ions from the target to form the first layer or the A layer. **In** the case of forming the first layer, the composition of the target is adjusted such that the ratio of Ti, Al, and Sc is the same as the ratio of the composition of the first layer in Table 1. In the case of forming the A layer, the composition of the target is adjusted such that the ratio of Ti, Al, Sc, B, and Si is the same as the ratio of the composition of the A layer in Tables 2 and 3. When the thickness of the first layer or the A layer reached the thickness shown in Tables 1, 2, and 3, the current supplied to the evaporation source was stopped.

In the case of forming the third layer on the first layer or in the case of forming the C layer on the A layer, the following steps were performed.

In the case where the third layer or the C layer consisted of TiCN, while introducing nitrogen and methane gas into the apparatus as reaction gas, an arc current of 150 A was supplied to the target with the temperature of substrate 2 being maintained at 500°C, the reaction gas pressure being maintained at 2 Pa, and the voltage of the bias power source being maintained at a certain constant value in a range of 100 V to 500 V, thereby generating metal ions from the target to form the third layer or the C layer. The composition of the target is Ti. When the thickness of the third layer or the C layer reached the thickness shown in Tables 1 to 3, the current supplied to the evaporation source was stopped.

In the case where the third layer or the C layer consisted of TiAlScMCN, while introducing nitrogen and methane gas into a chamber 101 as reaction gas, an arc current of 150 A was supplied to the target with the temperature of substrate 2 being maintained at 500°C, the reaction gas pressure being maintained at 2 Pa, and the voltage of the bias power source being maintained at a certain constant value in a range of 100 V to 500 V, thereby generating metal ions from the target to form the third layer or the C layer. The composition of the target used for forming the third layer is the same as the composition of the target used for forming the first layer. The composition of the target used for forming the C layer is the same as the composition of the target used for forming the A layer. When the thickness of the third layer or the C layer reached the thickness shown in Tables 1 to 3, the current supplied to the evaporation source was stopped. As described above, the cutting tool of each sample was obtained.

### [Table 1]

**Table 1**

| Sample No. | First Layer | | | Second Layer | | Third Layer | | Thickness of Coating Film [µm] | Cutting Test 1 |
|---|---|---|---|---|---|---|---|---|---|
| | Ti_{1-a-b}AlₐSc_{b}N | | Thickness [µm] | Composition | Thickness [nm] | Composition | Thickness [µm] | | Cutting Distance [m] |
| | a | b | | | | | | | |
| 1 | 0.35 | 0.01 | 0.3 | - | - | - | - | 0.3 | 30 |
| 2 | 0.35 | 0.05 | 0.5 | - | - | - | - | 0.5 | 32 |
| 3 | 0.35 | 0.10 | 1.0 | - | - | - | - | 1.0 | 31 |
| 4 | 0.50 | 0.05 | 3.0 | - | - | - | - | 3.0 | 46 |
| 5 | 0.65 | 0.01 | 5.0 | - | - | - | - | 5.0 | 31 |
| 6 | 0.65 | 0.09 | 8.0 | - | - | - | - | 8.0 | 32 |
| 7 | 0.65 | 0.10 | 10.0 | - | - | - | - | 10.0 | 32 |
| 8 | 0.40 | 0.02 | 15.0 | - | - | - | - | 15.0 | 25 |
| 9 | 0.45 | 0.03 | 2.0 | - | - | - | - | 2.0 | 30 |
| 10 | 0.50 | 0.04 | 4.0 | - | - | - | - | 4.0 | 46 |
| 11 | 0.55 | 0.07 | 7.0 | - | - | - | - | 7.0 | 42 |
| 12 | 0.60 | 0.08 | 12.0 | - | - | - | - | 12.0 | 36 |
| 13 | 0.35 | 0.05 | 0.5 | TiC | 10 | - | - | 0.5 | 36 |
| 14 | 0.35 | 0.10 | 1.0 | TiCN | 100 | - | - | 1.1 | 40 |
| 15 | 0.50 | 0.05 | 3.0 | - | - | TiCN | 0.1 | 3.1 | 50 |
| 16 | 0.65 | 0.01 | 5.0 | - | - | TiAIScCN | 10 | 6.0 | 35 |
| 17 | 0.65 | 0.09 | 8.0 | TiCN | 100 | TiAIScCN | 0.1 | 8.2 | 37 |
| 101 | 0.30 | 0.01 | 0.3 | - | - | - | - | 0.3 | 6 |
| 102 | 0.35 | 0.004 | 0.3 | - | - | - | - | 0.3 | 2 |
| 103 | 0.70 | 0.10 | 10.0 | - | - | - | - | 10.0 | 10 |
| 104 | 0.65 | 0.12 | 10.0 | - | - | - | - | 10.0 | 18 |
| 105 | 0.50 | 0.000 | 3.0 | - | - | - | - | 3.0 | 22 |

### [Table 2]

**Table 2**

| Sample No. | A Layer | | | | | B Layer | | C Layer | | Thickness of Coating Film [µm] | Cutting Test 2 |
|---|---|---|---|---|---|---|---|---|---|---|---|
| | Ti_{1-c-d-e}Al_{c}Sc_{d}MₑN | | | | Thickness [µm] | Composition | Thickness [nm] | Composition | Thickness [µm] | | Cutting Distance [m] |
| | c | d | e | M | | | | | | | |
| 21 | 0.35 | 0.01 | 0.01 | B | 0.3 | - | - | - | - | 0.3 | 22 |
| 22 | 0.35 | 0.01 | 0.01 | Si | 0.3 | - | - | - | - | 0.3 | 21 |
| 23 | 0.35 | 0.05 | 0.02 | B | 0.5 | - | - | - | - | 0.5 | 32 |
| 24 | 0.35 | 0.10 | 0.05 | Si | 1.0 | - | - | - | - | 1.0 | 27 |
| 25 | 0.50 | 0.05 | 0.03 | B | 3.0 | - | - | - | - | 3.0 | 40 |
| 26 | 0.65 | 0.01 | 0.01 | Si | 5.0 | - | - | - | - | 5.0 | 25 |
| 27 | 0.65 | 0.09 | 0.04 | B | 8.0 | - | - | - | - | 8.0 | 28 |
| 28 | 0.65 | 0.10 | 0.05 | B | 10.0 | - | - | - | - | 10.0 | 28 |
| 29 | 0.65 | 0.10 | 0.05 | Si | 10.0 | - | - | - | - | 10.0 | 31 |
| 30 | 0.40 | 0.02 | 0.01 | B | 15.0 | - | - | - | - | 15.0 | 24 |
| 31 | 0.45 | 0.03 | 0.02 | Si | 2.0 | - | - | - | - | 2.0 | 29 |
| 32 | 0.50 | 0.04 | 0.03 | Si | 4.0 | - | - | - | - | 4.0 | 36 |
| 33 | 0.55 | 0.07 | 0.04 | B,Si | 7.0 | - | - | - | - | 7.0 | 38 |
| 34 | 0.60 | 0.08 | 0.05 | Si | 12.0 | - | - | - | - | 12.0 | 35 |
| 35 | 0.35 | 0.05 | 0.02 | B | 0.5 | TiCNO | 10 | - | - | 0.5 | 33 |
| 36 | 0.35 | 0.10 | 0.05 | Si | 1.0 | TiCN | 100 | - | - | 1.1 | 31 |
| 37 | 0.50 | 0.05 | 0.03 | B | 3.0 | - | - | TiCN | 0.1 | 3.1 | 42 |
| 38 | 0.65 | 0.01 | 0.01 | Si | 5.0 | - | - | TiAlScSiCN | 1.0 | 6.0 | 34 |
| 39 | 0.65 | 0.09 | 0.04 | B | 8.0 | TiN | 100 | TiAIScBCN | 0.1 | 8.2 | 35 |

### [Table 3]

**Table 3**

| Sample No. | A Layer | | | | | B Layer | | C Layer | | Thickness of Coating Film [µm] | Cutting Test 2 |
|---|---|---|---|---|---|---|---|---|---|---|---|
| | Ti_{1-c-d-e}Al_{c}Sc_{d}MₑN | | | | Thickness [µm] | Composition | Thickness [nm] | Composition | Thickness [µm] | | Cutting Distance [m] |
| | c | d | e | M | | | | | | | |
| 121 | 0.30 | 0.01 | 0.01 | B | 0.3 | - | - | - | - | 0.3 | 14 |
| 122 | 0.35 | 0.004 | 0.01 | B | 0.3 | - | - | - | - | 0.3 | 13 |
| 123 | 0.30 | 0.01 | 0.01 | Si | 0.3 | - | - | - | - | 0.3 | 14 |
| 124 | 0.35 | 0.004 | 0.01 | Si | 0.3 | - | - | - | - | 0.3 | 13 |
| 125 | 0.70 | 0.10 | 0.05 | B | 10.0 | - | - | - | - | 10.0 | 17 |
| 126 | 0.65 | 0.12 | 0.05 | B | 10.0 | - | - | - | - | 10.0 | 19 |
| 127 | 0.65 | 0.10 | 0.06 | B | 10.0 | - | - | - | - | 10.0 | 17 |
| 128 | 0.70 | 0.10 | 0.05 | Si | 10.0 | - | - | - | - | 10.0 | 20 |
| 129 | 0.65 | 0.12 | 0.05 | Si | 10.0 | - | - | - | - | 10.0 | 18 |
| 130 | 0.65 | 0.10 | 0.06 | Si | 10.0 | - | - | - | - | 10.0 | 18 |
| 131 | 0.50 | 0.000 | 0.000 | - | 3.0 | - | - | - | - | 3.0 | 18 |
| 132 | 0.50 | 0.000 | 0.03 | B | 3.0 | - | - | - | - | 3.0 | 20 |
| 133 | 0.50 | 0.000 | 0.03 | Si | 4.0 | - | - | - | - | 4.0 | 20 |

### [Evaluation]

In the cutting tool of each sample, the composition and thickness of each of the first layer, the second layer, the third layer, the A layer, the B layer, and the C layer were measured by the methods described in the first embodiment and the second embodiment. The results are shown in Tables 1 to 3.

### [Cutting Test 1]

Each of the ball end mills of samples 1 to 17 and samples 101 to 105 was used to perform side surface processing of a workpiece consisting of Inconel 718. A processing condition was as follows: a cutting speed Vc was 120 mm/min, a feed amount fz per cutting edge was 0.05 mm/t, a cut-in amount (axial direction) ap was 0.6 mm, a cut-in amount (radial direction) ae was 0.6 mm, and oil was externally supplied. A cutting distance until the wear width or breakage width of the cutting edge reached 100 µm was measured. A longer cutting distance indicates a longer tool life. The results are shown in the column "Cutting Distance" of "Cutting Test 1" in Table 1. It should be noted that the above-described processing condition corresponds to difficult-to-cut material processing.

Each of the cutting tools of samples 1 to 17 correspond to an example of the present disclosure. Each of the cutting tools of samples 101 to 105 corresponds to a comparative example. It was confirmed that the cutting tools of samples 1 to 17 had longer tool lives than those of the cutting tools of samples 101 to 105.

### [Cutting Test 2]

Each of the ball end mills of samples 21 to 39 and samples 121 to 133 was used to perform side processing of a workpiece consisting of Inconel 718. A processing condition was as follows: a cutting speed Vc was 80 mm/min, a feed amount fz per cutting edge was 0.04 mm/t, a cut-in amount (axial direction) ap was 0.3 mm, a cut-in amount (radial direction) ae was 0.3 mm, and oil was externally supplied. A cutting distance until the wear width or breakage width of the cutting edge reached 100 µm was measured. A longer cutting distance indicates a longer tool life. The results are shown in the column "Cutting Distance" of "Cutting Test 2" in Tables 2 and 3. It should be noted that the above-described processing condition corresponds to difficult-to-cut material processing.

Each of the cutting tools of samples 21 to 39 corresponds to an example of the present disclosure. Each of the cutting tools of samples 121 to 133 corresponds to a comparative example. It was confirmed that the cutting tools of samples 21 to 39 had longer tool lives than those of the cutting tools of samples 121 to 133.

Although the embodiments and examples of the present disclosure have been described as described above, it is also initially expected to appropriately combine or variously modify the configurations of the above-described embodiments and examples.

The embodiments and examples disclosed herein are illustrative and non-restrictive in any respect. The scope of the present invention is defined by the terms of the claims, rather than the embodiments and examples described above, and is intended to include any modifications within the scope and meaning equivalent to the terms of the claims.

### REFERENCE SIGNS LIST

3: cutting edge ridgeline; 10 cutting tool; 11 substrate; 12 first layer; 12A A layer; 13 third layer; 13C C layer; 14 coating film; 15 second layer; 15B B layer.

## Claims

1. A cutting tool comprising: a substrate; and a coating film disposed on the substrate, wherein
the coating film includes a first layer consisting of Ti_{1-a-b}AlₐSc_{b}N,
the a is 0.35 or more and 0.65 or less, and
the b is 0.01 or more and 0.10 or less.

2. The cutting tool according to claim 1, wherein a thickness of the first layer is 0.3 µm or more and 15.0 µm or less.

3. The cutting tool according to claim 1 or 2, wherein
the coating film further includes a second layer disposed between the substrate and the first layer,
the second layer consists of a compound consisting of titanium and at least one element selected from a group consisting of carbon, nitrogen, and oxygen, and
a thickness of the second layer is 10 nm or more and 100 nm or less.

4. The cutting tool according to any one of claims 1 to 3, wherein
the coating film further includes a third layer provided on a side of the first layer opposite to the substrate,
the third layer consists of TiCN or TiAlScCN, and
a thickness of the third layer is 0.1 µm or more and 1.0 µm or less.

5. A cutting tool comprising: a substrate; and a coating film disposed on the substrate, wherein
the coating film includes an A layer consisting of Ti_{1-c-d-e}Al_{c}Sc_{d}MₑN,
the M is one or both of boron and silicon,
the c is 0.35 or more and 0.65 or less,
the d is 0.01 or more and 0.10 or less, and
the e is 0.01 or more and 0.05 or less.

6. The cutting tool according to claim 5, wherein a thickness of the A layer is 0.3 µm or more and 15.0 µm or less.

7. The cutting tool according to claim 5 or 6, wherein
the coating film further includes a B layer disposed between the substrate and the A layer,
the B layer consists of a compound consisting of titanium and at least one element selected from a group consisting of carbon, nitrogen, and oxygen, and
a thickness of the B layer is 10 nm or more and 100 nm or less.

8. The cutting tool according to any one of claims 5 to 7, wherein
the coating film further includes a C layer provided on a side of the A layer opposite to the substrate,
the C layer consists of TiCN or TiAlScMCN,
the M is one or both of boron and silicon, and
a thickness of the C layer is 0.1 µm or more and 1.0 µm or less.
